# EUROPÄISCHE PATENTSCHRIFT

(11) **EP 1 599 613 B1**
(45) Veröffentlichungstag und Bekanntmachung des Hinweises auf die Patenterteilung: **28.06.2006**
(21) Anmeldenummer: 04716206.0
(22) Anmeldetag: 02.03.2004
(51) Int. Cl.: C23C 16/02, C23C 16/18

(54) **VERFAHREN ZUR BESCHICHTUNG EINES SUBSTRATES**
METHOD FOR COATING A SUBSTRATE
PROCEDE POUR APPLIQUER UN REVETEMENT SUR UN SUBSTRAT

(30) Priorität: 03.03.2003 DE 10309359
(43) Veröffentlichungstag der Anmeldung: 30.11.2005
(73) Patentinhaber: DECHEMA Gesellschaft für Chemische Technik und Biotechnologie e.V., 60486 Frankfurt (DE)
(72) Erfinder: DITTMEYER, Roland, 61440 Oberursel (DE); REIF, Martin, 60486 Frankfurt (DE)
(74) Vertreter: Hebing, Norbert
(86) Internationale Anmeldenummer: PCT/DE2004/000390
(87) Internationale Veröffentlichungsnummer: WO 2004/079041

(56) Entgegenhaltungen:
- WO-A-01/78123
- DE-A- 19 607 437
- J. L. LIN ET AL.: "Carbon-Halogen Bond dissociation on Copper Surfaces. Effect of Alkyl Chain Length" J. PHYS. CHEM., Bd. 96, 1992, Seiten 8529-8538, XP002288832 1992

## Beschreibung

Die Erfindung betrifft ein Verfahren zur Beschichtung eines Substrates mit einem Metall oder einer Metallverbindung, bei welchem das Substrat mittels einer gasförmigen, metallorganischen Ausgangsverbindung beschichtet wird.

Solche Beschichtungsverfahren sind unter dem Begriff CVD (Chemical Vapor Deposition) allgemein bekannt und gebräuchlich. Die chemische Gasphasenabscheidung wird im allgemeinen vielfältig zur Abscheidung dünner Filme eingesetzt. Abgeschieden werden können Metalle, wie z.B. Silizium bei der Halbleiterherstellung, oder unterschiedliche Metalle bei der Leiterbahnenherstellung oder metalloxidische Verbindungen als Korrosionsschutzschicht, sowie Hartstoffschichten zur Oberflächenhärtung.

Zur chemischen Gasphasenabscheidung von metallorganischen Verbindungen kommen hauptsächlich zwei Typen von thermischen Reaktoren zum Einsatz, Heißwandreaktor und Kaltwandreaktor. Das zu beschichtende Substrat sowie nahezu der gesamte Reaktor werden beim Heißwandreaktor von außen über einen Ofen auf Reaktions- bzw. Abscheidetemperatur gebracht. Das Precursorgas wird in den meisten Fällen mit einem inerten oder reaktionsfähigen (enthält z.B. H₂) Trägergas zum Substrat transportiert und dort thermisch zersetzt. Die Zersetzung kann entweder in der Gasphase erfolgen, wobei reaktive Zwischenstufen entstehen, die anschließend am Substrat adsorbieren und dort zum gewünschten Produkt weiterreagieren. Oder der Precursor adsorbiert zunächst auf dem Substrat und zerfällt dann auf der Oberfläche durch Energiezufuhr in die gewünschten Produkte. Entstehende gasförmige Zersetzungsprodukte werden anschließend mit dem Trägergas wieder aus dem Reaktionsraum transportiert. Ein großer Nachteil von Heißwand-CVD-Reaktoren ist die gleichzeitige Beheizung von Reaktor und Substrat von außen. Dadurch findet die Abscheidung nicht nur auf dem Substrat, sondern auch auf den Reaktorwänden statt. Bei Kaltwandreaktoren wird der Reaktor nicht von außen über einen Ofen beheizt, sondern die Abscheidung findet auf einer beheizten Substratoberfläche statt. Das Substrat muss dazu gezielt aufgeheizt werden. Die Beheizung unterschiedlicher Geometrien kann sich dabei apparativ besonders schwierig gestalten.

Stofftransportvorgänge haben bei den beiden thermischen Reaktortypen einen entscheidenden Einfluss auf die Abscheidung. Diese sind unter anderem von den Strömungsverhältnissen im Reaktor und damit von der Reaktorgeometrie, sowie von einer Vielzahl von Reaktionsbedingungen (Temperatur, Precursorkonzentration, Reaktordruck, Trägergasfluss etc.) abhängig. Im allgemeinen gestaltet sich eine Optimierung des Abscheideprozesses äußerst langwierig und schwierig. Eine gleichmäßige Beschichtung kann bei größeren Substratflächen nicht erreicht werden, da sich die Precursorkonzentration über die Länge des Reaktors ändert. Am Reaktoreintritt ist die Konzentration und damit die Abscheiderate hoch, zum Ende hin nimmt die Konzentration und die Abscheiderate ab. Aufgrund einer unvollständigen Zersetzung bzw. Abscheidung des Precursors, verlässt zudem ein Großteil ungenutzt den Reaktionsraum mit dem Trägergas.

Neben den thermischen CVD-Verfahren gibt es auch die photounterstützte und die plasmaunterstützte chemische Gasphasenabscheidung. Bei der ersteren wird Licht, bevorzugt Laserlicht, zur Zersetzung des Precursors und damit zum Aufbau der Schicht verwendet. Bei der plasmaunterstützten chemischen Gasphasenabscheidung dienen Elektronen als Energiequelle, die in einem hochfrequenten elektrischen Feld erzeugt werden. Die Precursormoleküle werden durch Stöße mit den Elektronen angeregt. Dadurch werden Radikale erzeugt, die auf die Substratoberfläche treffen und dort die abzuscheidende Schicht bilden. Der eigentliche Vorteil der plasmaunterstützten Gasphasenabscheidung ist die im Gegensatz zur thermischen Zersetzung des Precursors niedrigere Abscheidetemperatur. Allerdings weisen die plasmaunterstützte und die photounterstützte Gasphasenabscheidung die gleichen Nachteile wie die thermische Abscheidung auf. Zudem ist ein höherer apparativer Aufwand nötig.

Die klassische Abscheidemethode der Katalysatorpräparation ist die Nassimprägnierung. Dazu werden Salze oder andere Verbindungen in Wasser oder organischen Lösungsmitteln gelöst und auf ein Trägermaterial aufgebracht. Nach dem Verdampfen des Lösungsmittels wird die katalytisch aktive Komponente häufig durch Calcinierung auf dem Träger fixiert und in einem weiteren Schritt aktiviert. Chemisch inerte Materialien, die keine aktiven Zentren auf der Oberfläche und nur eine geringe Porosität aufweisen, können mit Hilfe der Nassimprägnierung nur sehr schlecht beschichtet werden. Beim Trocknen können sich zudem durch Zusammenziehen der Flüssigkeit und durch Tropfenbildung große Kristalle an einzelnen Stellen bilden. Insgesamt ergibt sich bei solchen Materialien bei der Nassimprägnierung eine ungenügende und ungleichmäßige Abscheidung der Aktivkomponenten, eine mangelhafte Fixierung auf der Trägeroberfläche und eine niedrige katalytische Aktivität.

US-Patent 4,870,030 beschreibt ein CVD-Verfahren, bei dem neben dem Trägergas mit Precursor ein zweiter Gasstrom verwendet wird, der aus einem Edelgas oder Wasserstoff besteht. Dieser zweite Gasstrom wird vor Eintritt in den Reaktor in einem Hochfrequenzfeld (Plasmaerzeugung) angeregt. Beide Gase treffen im Reaktor aufeinander. Durch die Bereitstellung des aktivierten Gases können temperaturempfindliche Halbleitersubstrate bei niedrigeren Temperaturen beschichtet werden.

Die Patente US 6,132,514, US 6,040,010 und US 6,306,776 berichten von einer intensivierten Abscheidung von Silizium- oder Titan-Filmen auf Halbleiter-Wafern, bei der ein Katalysator verwendet wird, z.B. Ruthenium, Rhodium, Palladium, Osmium, Iridium, Platin, Gold, Silber etc., um ein reaktives Gas, das Wasserstoff enthält oder freisetzen kann, wie z.B. H₂, HCl, SiH₄, bei 500 bis 600°C zu aktivieren. Das so aktivierte Gas und das mit Precursor beladene Trägergas werden einzeln von zwei verschiedenen Seiten in den CVD-Reaktor geleitet. Die abzuscheidenden Metalle können dadurch ebenfalls bei niedrigeren Temperaturen auf den Halbleitermaterialien abgeschieden werden.

Das US-Patent 5,403,620 schildert ein CVD-Verfahren, das auch plasmaunterstützt oder laserinduziert betrieben werden kann, bei dem organische Wolframverbindungen gemeinsam mit kleinen Mengen katalytisch wirkender Substanzen (z.B. Organoplatinverbindungen) in Gegenwart von Wasserstoff abgeschieden werden. Durch den Einsatz dieser kleinen Mengen an katalytischem Metall werden Wolframfilme mit höherer Reinheit, d.h. mit weniger verunreinigungen an Kohlenstoff oder Fremdatomen, erhalten.

Die selektive Abscheidung von metallorganischen Komponenten wie Trimethylcyclopentadienyl-Platin in Gegenwart von Wasserstoff als Reduktionsgas auf Halbleiter-Wafern, die Wolfram oder Silizium/Wolfram-Verbindungen enthalten, wird bei US 5,130,172 erklärt. Die Abscheidung des Platins auf Wolfram erfolgt bei deutlich niedrigeren Temperaturen im Vergleich zu Oberflächen wie SiO₂, Si₃N₄, Si und GaAs. Durch Regelung der Substrattemperatur kann Platin somit selektiv auf Wolfram oder Silizium/Wolfram-Schichten abgeschieden werden.

In der internationalen Patentanmeldung WO 01/78123A1 wird ein Verfahren beschrieben, bei dem Jod oder jodhaltige Verbindungen als grenzenflächenaktive Substanzen eingesetzt werden. Das Jod katalysiert die Zersetzung des metallorganischen Precursors Cu(I)-Hexafluoracetylacetonat-Vinyltrimethylsilan. Die Abscheidetemperatur wird dadurch verringert und Kupfer wird selektiv an den Stellen mit Iod abgeschieden. Mit Hilfe dieses Verfahrens ist die Herstellung von Kupferleiterbahnen möglich.

Bei [Langmuir 1997, 13, 3833-3838] beschreiben Jeon et al. ein Verfahren, bei dem Leiterbahnen aus Palladium, Platin oder Kupfer in einem CVD-Kaltwandreaktor aus Edelstahl auf Substrate aus TiN, In₂O₃/SnO₂, SiO₂ auf Si, Saphir oder Borosilikatglas abgeschieden werden. Dünne Filme von Octadecyltrichlorsilan werden dazu zuvor per Microcontact Printing auf die Substrate aufgedruckt. Die Metallprecursoren werden anschließend selektiv auf den aufgedruckten Filmen abgeschieden.

Die Offenlegungsschrift DE 19607437A1 beschreibt eine Methode zur Herstellung von Pd-Schalenkatalysatoren. Beispielhaft wird Palladiumacetat als metallorganische Verbindung in Toluol gelöst und anschließend auf kugelförmige, poröse Katalysatorträger, z.B. aus Aluminiumoxid, aufgebracht. Durch die Imprägnierzeit wird die Durchdringung und somit die Dicke der schalenförmigen Katalysatorschicht bestimmt. Bei Verwendung eines Palladiumsalzes gelöst in wässrigen Lösungsmitteln ergibt sich eine gleichmäßige, durchgängige Beschichtung des Katalysatorkorns mit Palladium. Durch die Verwendung von metallorganischen Verbindungen gelöst in organischen Lösungsmitteln wie Benzol, Toluol, Xylol, Methanol oder Tetrahydrofuran können durch Nassimprägnierung oder in einem Sprühverfahren Schalenkatalysatoren erzeugt werden.

Offenlegungsschrift DE 19827844A1 beschreibt eine CVD-Methode zur Herstellung von Pd/Au-Schalenlcatalysatoren auf porösen Trägerformkörpern. Geeignete Edelmetallprecursoren werden über die Dampfphase auf dem Träger abgeschieden und anschließend thermisch oder chemisch zum Metall reduziert und dadurch auf dem Träger fixiert. Diese so hergestellten Pd/Au-Schalenkatalysatoren können bevorzugt bei der Vinylacetat-Synthese nach dem Wacker-Verfahren eingesetzt werden. Nach nicht genauer beschriebenen Angaben im Patent soll die Schalendicke über die CVD-Prozessparameter gesteuert werden können.

In der Offenlegungsschrift DE 10064622A1 wird ein Verfahren zur Nassimprägnierung keramischer, asymmetrischer, rohrförmiger Membranen mit katalytischen Metallen beansprucht. Zur Beschichtung wird die keramische Membran in einen Rotationsverdampfer gegeben, in dem sich die wässrige Imprägnierlösung befindet. Durch Anlegen eines Vakuums und unter Drehen des Verdampfers wird die Membran nacheinander mit den Aktivkomponenten Zinn und Palladium beschichtet. Ein großer Teil wird dabei in den grobporösen Träger der Membran abgeschieden. Allerdings ist nur die Beschichtung der feinporösen Deckschicht der asymmetrischen Membran wünschenswert. Zudem sind die abgeschiedenen Partikel nur teilweise fest mit der Trägeroberfläche verbunden. Die so hergestellten Membranen werden als katalytischer Kontaktor/Diffusor zur Entfernung von Nitrat und Nitrit mit Wasserstoff als Reduktionsmittel aus verunreinigtem Wasser eingesetzt.

Zusammenfassend kann festgestellt werden, dass die meisten beschriebenen CVD-Verfahren zur Abscheidung von dünnen Filmen dienen und mit ihnen keine hochdispersen Katalysatoren hergestellt werden können. Zudem sind die notwendigen CVD-Reaktoren apparatetechnisch sehr aufwendig und damit teuer, die Prozessparameter müssen genau eingehalten werden, um die erwünschte Abscheidung zu erhalten. Eine Beschichtung von großen Bauteilen mit Hilfe der chemischen Gasphasenabscheidung ist nur schwer zu realisieren und eine Übertragung von Laboranlagen in den großtechnischen Maßstab bereitet aufgrund unterschiedlicher Strömungsverhältnisse erhebliche Schwierigkeiten. Per Nassimprägnierung lässt sich nur wenig Material auf einem inerten Träger abscheiden, die Beschichtung ist zudem ungleichmäßig und die abgeschiedenen Partikel sind nicht fest mit der Oberfläche verbunden. Zudem lässt sich die Stelle, an der katalytische Komponenten auf einem Träger abgeschieden werden sollen, mit den herkömmlichen CVD-Verfahren oder durch Nassimprägnierung kaum oder nur schlecht steuern.

Es besteht daher ein Bedarf an einer einfachen und kostengünstigen Beschichtungsmethode zur Abscheidung von metallorganischen Ausgangsstoffen, insbesondere zur Abscheidung von katalytisch aktiven Metallen oder anderen katalytisch aktiven Komponenten in hochdisperser Form in poröse, anorganische Trägermaterialien, mit der auch inerte Materialien oder Materialien mit geringer Oberfläche gleichmäßig und reproduzierbar beschichtet werden können.

Dieses Problem wird erfindungsgemäß dadurch gelöst, dass vor der Beschichtung mittels der metallorganischen Ausgangsverbindung auf das Substrat ein organischer Lösungsvermittler für die metallorganische Ausgangsverbindung aufgebracht wird.

Bei der Erfindung handelt es sich um eine neu entwickelte CVD-Methode. Das zu beschichtende Trägermaterial wird zunächst mit einem organischen Lösungsvermittler vorbehandelt. Als organische Lösungsvermittler können z. B. halbfeste, reaktionsträge Paraffine mit Schmelzpunkten bzw. Erweichungsbereichen bevorzugt zwischen 30 C - 150 C und Siedepunkten bzw. Verdampfungsbereichen zwischen 80 C - 300°C oder beliebig andere, auch flüssige, organische Verbindungen mit Siedepunkten bis zu 300 C eingesetzt werden. Als besonders geeignet erwiesen hat sich klare, weiße Vaseline. Die Vaseline kann in beliebiger Weise, mit einem Pinsel, im erwärmten Zustand durch Aufsprühen oder einfach per Hand aufgetragen werden. Die chemische Gasphasenabscheidung eines metallorganischen Precursors wird anschließend nicht in einem herkömmlichen Heiß- oder Kaltwandreaktor durchgeführt, sondern in einem evakuierbarem Glasgefäß, z.B. einem evakuierbarem Glasrohr mit Schliff zum Anschluss eines Glashahns. Das zu beschichtende poröse Trägermaterial, das zuvor mit dem organischen Lösungsvermittler behandelt wurde, wird zusammen mit dem CVD-Precursor in das Glasgefäß gegeben. Über einen angeschlossenen Glashahn erfolgt die Evakuierung des Glasgefäßes mit einer Vakuumpumpe. Danach wird das evakuierte Gefäß in einen Ofen gegeben, dessen Temperatur mit der Zeit erhöht wird. Bei der Erwärmung des Substrats verteilt sich der organische Lösungsvermittler gleichmäßig. Der abzuscheidende metallorganische Precursor sublimiert zunächst mit steigender Temperatur und löst sich dann bevorzugt in dem organischen Lösemittel. Anschließend verdampft der Lösungsvermittler mit weiter zunehmender Temperatur (ca. 200°C). Die chemische Gasphasenabscheidung findet innerhalb einer Zeit von ca. 2 Stunden statt. Somit wird dem Precursor genügend Zeit gegeben zu sublimieren, durch Diffusion zur Trägeroberfläche transportiert zu werden, auf der Oberfläche des Trägers zu adsorbieren bzw. sich im organischen Lösungsmittel zu lösen und sich anschließend zu zersetzten. Dadurch sind die Stofftransportvorgänge, sowie die Strömungsverhältnisse und die Reaktorgeometrie nicht mehr entscheidend. Zudem wird unverbrauchter Precursor nicht mit einem Trägergas vom Substrat wegtransportiert. Auch größere Substrate können so problemlos gleichmäßig beschichtet werden. Als Resultat wird der metallorganische Precursor dort auf dem zu beschichtenden Träger abgeschieden, wo sich zuvor der organische Lösungsvermittler befand. Nur ein geringer Teil des metallorganischen Precursors scheidet sich auf den Glaswänden ab. Durch diese Beschichtungsmethode kann die Abscheideeffizienz deutlich erhöht werden, z. B. werden für Palladium Abscheideraten von 60 % - 90 % erreicht. Dies ist von besonderer Bedeutung bei teuren Edelmetallprecursoren. Der Ort der Beschichtung, sowie die Eindringtiefe in eine poröse Struktur kann zudem durch das vorherige Aufbringen des Lösungsvermittlers (Menge, Eindringzeit) gezielt gesteuert werden. Es können auch inerte Materialien mit niedriger spezifischer Oberfläche beschichtet werden. Zudem besteht nach der Beschichtung eine feste Verbindung zwischen dem abgeschiedenem Metall und dem Substrat. Ein Auswaschen (Leaching) und somit der Verlust der katalytischen Komponente bei Verwendung von flüssigen Reaktionsgemischen wird somit verhindert. Das abzuscheidende Metall wird in Form von kleinen metallischen Clustern auf dem Träger abgeschieden, mit der Methode können also hochdisperse Katalysatoren hergestellt werden.

Durch die erfindungsgemäße Methode können neben Metallen auch andere katalytische Komponenten abgeschieden werden. Zudem können nicht nur poröse, anorganische Materialien beschichtet werden, sondern die Abscheidung katalytischer Komponenten ist auch auf unporösen, rauen Oberflächen möglich. Das erfindungsgemäße Verfahren hat sich als besonders geeignet zur Beschichtung poröser, keramischer oder kohlenstoffhaltiger Membranen mit katalytisch aktiven Metallen erwiesen.

Durch die folgenden detaillierten Beispiele soll die Erfindung genauer beschrieben und die Vorteile der Erfindung deutlich gemacht werden.

### Beispiel 1: Entdeckung der Erfindung

Mehrere Versuche zur Abscheidung von Palladium mit Palladium(II)-Hexafluoracetylacetonat als metallorganischem Precursor auf keramischen, rohrförmigen Membranen mit einem Außendurchmesser von 10 mm und einer Länge von 10 cm haben gezeigt, dass eine Abscheidung in einem Heißwandreaktor nur unbefriedigende Ergebnisse liefert. Eine gleichmäßige Beschichtung über die ganze Länge oder die kreisförmige äußere Fläche der Membran zu erhalten, war nicht möglich. Aufgrund der sich verändernden Precursorkonzentration wurde auf der einen Seite zum Reaktoreintritt hin mehr abgeschieden als zum Ende der Membran. Zudem wurde ein Großteil des Precursors ungenutzt mit dem Trägergas wieder aus dem Reaktor entfernt. Um dies zu verhindern wurde die CVD-Beschichtung in ein evakuierbares Glasrohr übertragen. Auch dort wurde nur wenig Palladium auf der inerten Membranoberfläche (α-Al₂O₃) abgeschieden. Allerdings zeigte sich bei Beschichtungsversuchen überraschenderweise Abscheidungen von Palladium an Stellen auf der Außenseite der keramischen Membran, wo zuvor Spuren von Fett aufgebracht wurden. Die Beschichtung hatte also dort stattgefunden, wo sich das Fett befand, da der metallorganische Precursor sich bevorzugt darin löste.

Die Idee war nun durch gezieltes Aufbringen eines organischen Lösungsvermittlers, die Abscheiderate zu erhöhen und den Abscheideort bewusst zu steuern.

### Beispiel 2: Chemische Gasphasenabscheidung von Palladium auf keramischen Membranen

Das folgende Beispiel beschreibt die vorteilhafte Abscheidung von Palladium auf rohrförmigen, keramischen Membranen in Form kleiner Metallcluster zur Herstellung katalytisch aktiver Membranen, kann aber auch leicht auf andere katalytisch aktive Metalle wie z.B. Platin, Rhodium, Silber, Gold, Nickel, Kupfer, Zink, Zinn etc. oder auf andere zu beschichtende keramische oder kohlenstoffhaltige Substrate übertragen werden.

Die zu beschichtenden keramischen Membranen haben eine asymmetrische Struktur, sie bestehen aus einem grobporösen Träger aus α-Al₂O₃ und einer dünnen, feinporösen Schicht auf der Außenseite der Membran. Die feinporöse Deckschicht kann aus verschiedenen keramischen Materialien wie Al₂O₃, ZrO₂, TiO₂ usw. bestehen. Die Poren der Deckschicht weisen typischerweise mittlere Porendurchmesser zwischen 5 nm und 400 nm auf, der grobporöse Träger verfügt typischerweise über mittlere Porendurchmesser von etwa 3 µm. Die Membranen sind kommerziell erhältlich und werden üblicherweise in der Ultra- und Mikrofiltration eingesetzt. Wird die Deckschicht dieser Membranen mit katalytisch aktiven Metallen oder anderen katalytisch aktiven Komponenten beschichtet, können diese Membranen für Gas-Flüssig-Reaktionen, z.B. für Hydrierreaktionen mit Wasserstoffgas, eingesetzt werden. Das gasförmige Edukt wird dazu in das Innere der rohrförmigen Membran und somit über den grobporösen Träger an die katalytische Schicht geleitet. Das zweite Edukt wird als Flüssigkeit oder gelöst in einer Flüssigkeit von der Außenseite her an die katalytische Schicht herantransportiert. Durch Kapillarkräfte wird die Flüssigkeit in die Poren der feinporösen Schicht gesaugt. Der Druck im Innern der Membran ist jedoch so groß, dass sich keine Flüssigkeit im grobporösen Träger befindet. Die beiden Edukte werden somit von zwei verschiedenen Seiten an die katalytische Schicht herantransportiert. Aufgabe der Beschichtung ist es, die katalytisch aktiven Komponenten nur in der feinporösen Deckschicht und nicht in den grobporösen Träger der Membran abzuscheiden, da die katalytischen Komponenten nur in der Deckschicht mit beiden Edukten in Kontakt kommen können. Typischerweise werden rohrförmige, keramische Membranen mit einem Außendurchmesser von 10 mm und einer Länge von 10 cm verwendet. Die Dicke der Deckschicht beträgt 1 µm bis 40 µm.

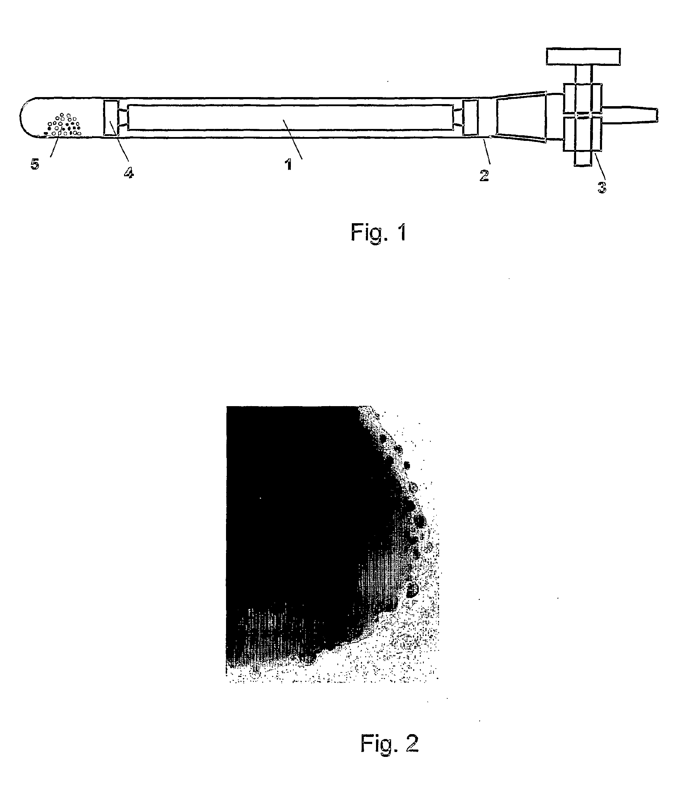

Vor der Beschichtung der Membran mit Palladium bestimmt man durch Wiegen das Gewicht der Membran, damit später die Menge des abgeschiedenen Palladiums festgestellt werden kann. Um das Palladium nur in die äußere feinporöse Schicht abzuscheiden, wird die Membran mit einem Lösungsvermittler vorbehandelt. Es hat sich gezeigt, dass klare, weiße Vaseline sich besonders gut eignet. Die Vaseline wird auf die Außenseite der Membran aufgebracht, gleichmäßig verteilt und kurze Zeit später mit Papiertüchern wieder vollständig entfernt. Wichtig ist, dass die oberflächige Vaseline nach dem Aufbringen wieder vollständig entfernt wird, so verbleibt nur eine kleine Menge Vaseline in den Poren der porösen Membran. In die Enden der rohrförmigen Membran (1, siehe Fig. 1) werden zwei konusförmige Glasstopfen mit Teflonabdichtung (4) gesteckt. In einem Glasrohr (2) mit einem Volumen von etwa 25 ml mit Schliff zum Anschluss eines Glashahns (3) wird 100 mg des Palladium-Precursors (5) gegeben. Als Palladium-Precursor wird Palladium(II)-Hexafluoracetylacetonat (Aldrich 401471) verwendet. Die Membran mit den Glasstopfen wird in das Glasrohr überführt. Der äußere Durchmesser der Glasstopfen ist etwas größer als der Durchmesser der Membran. Dadurch wird verhindert, dass die keramische Membran im Glasrohr auf der Glaswand aufliegt. Zudem lässt sich dadurch vermeiden, dass der organische Precursor in das Rohrinnere eindringt. Das Glasrohr wird anschließend mit einem Glashahn (3) verschlossen. Zum Abdichten der Schliffverbindung wird Hochtemperatur-Schlifffett verwendet, die Verbindung zwischen Glasrohr und Glashahn wird mit einer Metallklammer gesichert. Anschließend wird mit einer Vakuumpumpe die Luft aus dem Glasrohr entfernt und ein Vakuum im Glasrohr von etwa 3 mbar Absolutdruck oder kleiner erzeugt. Nach dem Schließen des Glashahns überführt man das evakuierte Glasrohr in einen Laborofen, dessen Temperatur sich auf 150 °C befindet. Innerhalb von 30 Minuten wird die Temperatur des Ofens auf 250 °C erhöht. Nachdem die Temperatur von 250 °C erreicht ist, verbleibt das Glasrohr für weitere 2 Stunden im Ofen. Während dieser 2½ Stunden im Ofen wird die Vaseline flüssig und verteilt sich im Porensystem der feinporösen Membranschicht. Aufgrund der Kapillarkräfte wird die flüssige Vaseline allerdings in den kleineren Poren der feinporösen Schicht gehalten und dringt nicht in das grobporöse Trägermaterial ein, vorausgesetzt, es steht nur wenig Vaseline zur Verfügung. Der metallorganische Precursor sublimiert, und löst sich in der Vaseline. Gleichzeitig verdampft die Vaseline mit der Zeit. Das Palladium(II)-Hexafluoracetylacetonat zerfällt in metallisches Palladium und einen organischen Rest. Dadurch erhält man Palladium an den Stellen, wo sich zuvor die Vaseline befand. Das Palladium wird somit wie gewünscht nur in der dünnen, feinporösen Deckschicht der Membran abgeschieden, aber nicht in das Trägermaterial. Anschließend wird das heiße Glasrohr aus dem Ofen genommen und im Abzug geöffnet, damit die verdampfte Vaseline und die gasförmigen organischen Produkte, die beim Zerfall des Precursors entstehen, entweichen können.

Anschließend wird die Membran in einem Hochtemperaturofen auf eine Temperatur von 400 °C im Luftstrom erhitzt (Heizrate 2 K/min). Dadurch werden noch eventuell vorhandene organische Reste von der keramischen Membran abgebrannt. Das schwarz-graue Palladium oxidiert dadurch zu braunem Palladiumoxid. Die Membran verbleibt für 4 Stunden bei 400 °C im Ofen, danach wird mit 2 K/min bis auf Raumtemperatur abgekühlt. Das entstandene Palladiumoxid muss danach wieder zu metallischem Palladium reduziert werden. Dazu wird die Membran in ein weiteres Glasrohr überführt. Wasserstoffgas wird in das Glasrohr eingeleitet, dann das Glasrohr verschlossen und in einen Laborofen gegeben, der eine Temperatur von 150°C hat. Die Membran verbleibt 2 Stunden lang im Ofen, das Palladiumoxid wird dadurch zu Palladium reduziert. Nach dem Abkühlen wird die Membran getrocknet und kann anschließend gewogen werden, um die abgeschiedene Menge Palladium zu bestimmen.

Im Gegensatz zu herkömmlichen in der Literatur beschriebenen CVD-Beschichtungsmethoden ist die beschriebene Methode äußerst einfach. Für einen Heißwandreaktor oder Kaltwandreaktor mit beheiztem Substrat ist ein hoher apparativer und regelungstechnischer Aufwand nötig. Die beschriebene Methode kommt mit einem Glasrohr und einem üblichen Laborofen aus. Der technische Aufwand und daher die Kosten für die Beschichtung sind daher bedeutend geringer. Die beschriebene CVD-Methode ermöglicht eine gleichmäßige Beschichtung der keramischen Membranen über die gesamte Länge der Membran, da die CVD-Beschichtung im geschlossenem Glasrohr langsam abläuft und dem Precursor genügend Zeit zur Verfügung steht durch Diffusion an das Substrat herantransportiert zu werden. Bei einem herkömmlichen Heißwandreaktor wird der metallorganische Precursor mit einem Trägergas an das Substrat herantransportiert, d.h. der Precursor hat nur eine gewisse kurze Verweilzeit im Reaktor. Gleichzeitig ändert sich die Konzentration des Precursors und damit die Abscheiderate über die Länge des Reaktors. Am Reaktoreintritt ist die Precursorkonzentration und damit die Abscheidegeschwindigkeit hoch, zum Ende des Reaktors hin wird die Konzentration und die Abscheidegeschwindigkeit niedriger. Bei einer keramischen Rohrmembran bedeutet das, das an einem Ende der Membran viel und am anderen Ende wenig Palladium abgeschieden wird. Zudem kann die Verweilzeit im Reaktor zu kurz sein und somit unverbrauchter Precursor mit dem Trägergas wieder aus dem Reaktor heraustransportiert werden. Außerdem werden beim herkömmlichen Heißwandreaktor leicht die heißen Wände des Reaktors beschichtet. Insgesamt werden bei dem erfindungsgemäßen langsamen CVD-Abscheideprozess und unter Verwendung eines Lösungsvermittlers wie Vaseline sehr hohe Abscheideraten von 60 % - 90 % erreicht im Vergleich zu herkömmlichen CVD-Methoden, und die Abscheidung erfolgt gleichmäßig verteilt über die ganze Fläche der Membran. Speziell bei teuren Edelmetallen wie Palladium ist das von besonderer Bedeutung.

### Beispiel 3: Beschichtung von inerten Materialien und Charakterisierung der abgeschiedenen Metallpartikel mit der Transmissionselektronenmikroskopie

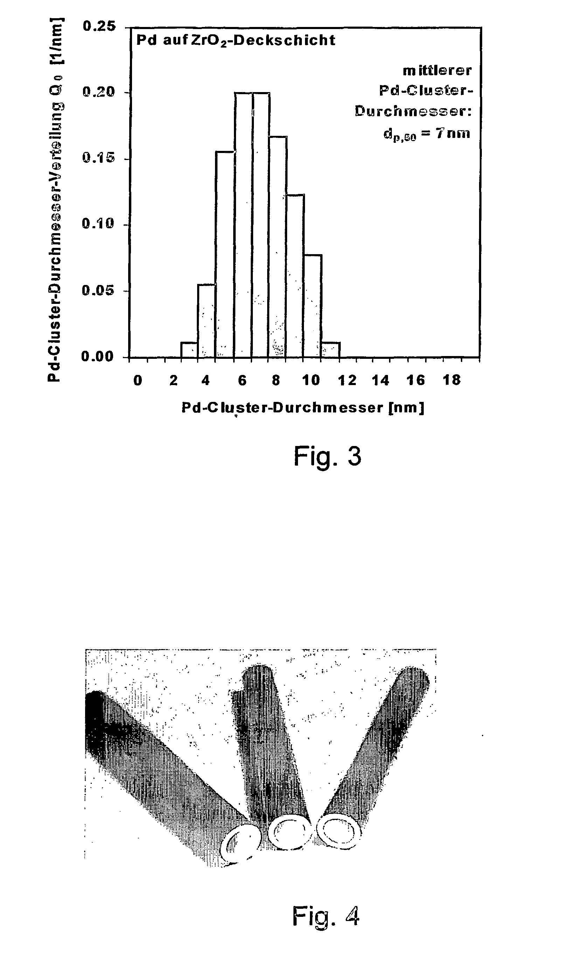

Mit Hilfe der erfindungsgemäßen Beschichtungsmethode können inerte keramische Materialien wie z.B. α-Al₂O₃ oder Materialien mit niedriger spezifischer Oberfläche beschichtet werden. Eine keramische Membran mit einer Deckschicht aus α-Al₂O₃ wurde nach der Vorschrift aus Beispiel 2 mit Palladium beschichtet. Beim nachfolgenden Einsatz der Membran für die Nitrat- und Nitritreduktion in einem wässrigen Reaktionsgemisch konnte keine Auslaugung des Palladiums und auch keine Desaktivierung der katalytisch aktiven Membran über einen Zeitraum von 2 Monaten festgestellt werden. Eine anschließende Charakterisierung der abgeschiedenen Palladium-Partikel mit Hilfe eines Transmissions-Elektronenmikroskops (TEM) konnte zeigen, dass die Metall-Cluster fest mit der keramischen Oberfläche verbunden sind. Die Palladium-Partikel liegen in Form von Halbkugeln auf dem Trägermaterial vor (siehe Fig. 2). Einzelne freistehende kugelförmige Metall-Cluster sind nicht vorhanden. Durch die feste Verbindung zwischen den Palladium-Clustern und dem keramischen Träger geht während der Reaktion in wässrigen oder organischen Lösungsmittel kein Palladium verloren. Mit einer TEM-Charakterisierung kann außerdem durch Messen der Cluster-Durchmesser auf einer TEM-Aufnahme eine Metallcluster-Durchmesserverteilung ermittelt werden. Fig. 3 zeigt eine typische Verteilung der Durchmesser der Palladiumcluster auf einer keramischen Membran mit einer Deckschicht aus ZrO₂. Der mittlere Palladium-Partikel-Durchmesser beträgt 7 nm. Das katalytische Metall wird also in feinverteilter Form als Nanopartikel auf keramischen Trägern abgeschieden. Die erfindungsgemäße Beschichtungsmethode eignet sich somit zur Herstellung hochdisperser Katalysatoren.

### Beispiel 4: Herstellung von dichten Palladium-Membranen zur Abtrennung von Wasserstoff aus Gasgemischen

Um eine dichte, fehlstellenfreie Schicht aus Palladium auf einer keramischen Membran oder einer Sintermetallmembran aufzubringen, kann eine stromlose, nasschemische Abscheidung (Electroless Plating) verwendet werden. Dazu werden auf der Membranoberfläche zunächst Palladiumkeime erzeugt, indem die Membran abwechselnd in salzsaure Zinnchlorid-Lösung (SnCl₂) und salzsaure Palladiumchlorid-Lösung (PdCl₂) getaucht wird. Dieser Vorgang wird drei bis zehnmal wiederholt. Durch Oxidation der Sn²⁺-Ionen zu Sn⁴⁺ werden dabei die Palladium-Ionen (Pd²⁺) zu elementarem Palladium reduziert. Anschließend wird das überschüssige zinnchlorid durch Spülen mit destillierten Wasser wieder entfernt. Diese Vorbeschichtung liefert relativ große (ca. 100 nm bis 200 nm) Palladiumpartikel in der Membrandeckschicht. Die Palladiumpartikel sind zudem nur ungenügend auf der Membranoberfläche fixiert, und die Beschichtung der Membran kann sehr ungleichmäßig erfolgen. Anschließend erfolgt die stromlose, nasschemische Abscheidung (Electroless Plating) von Palladium mit einer Beschichtungslösung von Palladiumchlorid gelöst in Ammoniakwasser, die mit Natrium-EDTA stabilisiert wurde. Zur dieser Lösung werden nacheinander die Reduktionsmittel Hydrazin und Formaldehyd gegeben. Anschließend wird eine vorbeschichtete Membran in die Beschichtungslösung gegeben und die Lösung erwärmt. Palladium wächst dabei auf den bei der Vorbeschichtung gebildeten Palladium-Keimen auf. Danach wird die Membran mit destilliertem Wasser gespült, getrocknet und erneut in frische Beschichtungslösung gegeben. Der Beschichtungsvorgang wird so oft wiederholt bis die gewünschte Schichtdicke erreicht ist und damit eine gasdichte, fehlstellenfreie Palladiumschicht auf der Membran aufgewachsen ist. Diese so hergestellten Membranen dienen zur Wasserstoffabtrennung aus Gasgemischen und können bei verschiedenen technischen Reaktionen eingesetzt werden.

Wird die beschriebene Vorbeschichtung mit abwechselnder Zugabe von salzsaurer Zinnchlorid-Lösung (SnCl₂) und salzsaurer Palladiumchlorid-Lösung (PdCl₂) ersetzt durch die erfindungsgemäße Beschichtungsmethode entsprechend Beispiel 2, so hat das folgende Vorteile: Für die Beschichtung reichen geringere Mengen an Palladium aus, da bei der CVD-Methode kleinere Palladium-Cluster (5 nm - 15 nm, anstatt 100 nm - 200 nm) in der Membrandeckschicht erzeugt werden. Zudem wird die Membran gleichmäßig beschichtet und die Palladium-Cluster liegen fest fixiert auf der keramischen Membran oder der Sintermetallmembran vor. Ein weiterer Vorteil bei der erfindungsgemäßen CVD-Methode besteht darin, dass auch auf rauen Membranoberflächen (z.B. auf einer Sintermetallmembran) Palladium-Cluster gleichmäßig auf der gesamten Oberfläche der Deckschicht auch an schlecht zugänglichen Stellen abgeschieden werden können, da der flüssige Lösungsvermittler sich gleichmäßig über die gesamte Oberfläche verteilt. Beschichtungsversuche haben gezeigt, dass bei Verwendung der erfindungsgemäßen CVD-Methode als Vorbeschichtung bedeutend geringere Menge Palladium beim anschließenden Electroless Plating abgeschieden werden müssen, um eine dichte Palladium-Schicht zur erzeugen. So reichen Palladium-Schichtdicken von 10 µm aus um eine fehlstellenfreie Schicht zu erzeugen. Bei der herkömmlichen Methode sind Schichtdicken von etwa 20 µm notwendig. Dadurch werden bedeutende Mengen des teuren Edelmetalls Palladium eingespart. Die feste Fixierung der mit der erfindungsgemäßen CVD-Methode abgeschiedenen Palladium-Cluster verhindert zudem ein späteres Abplatzen der Palladium-Schicht, die Lebensdauer der so hergestellten Membran wird dadurch entscheidend erhöht.

### Beispiel 5: Steuerung des Abscheideortes und Steuerung der Eindringtiefe in eine poröse keramische Struktur

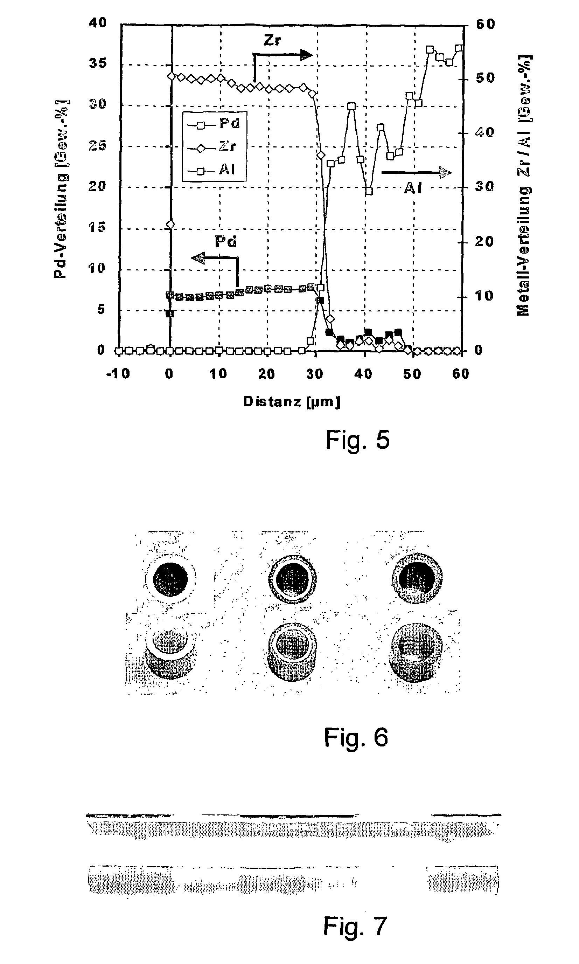

Wie im Beispiel 2 beschrieben, verteilt sich die flüssige Vaseline beim Erwärmen in der Deckschicht der Membran, sie wird allerdings aufgrund der Kapillarkräfte in den kleinen Poren der feinporösen Schicht gehalten und dringt somit nicht in die grobporöse Struktur des Trägers ein. Dadurch ist es möglich, das Palladium nur in der feinporösen Schicht der Membran aber nicht im Träger abzuscheiden (siehe Fig. 4). Mit herkömmlichen Methoden wie z.B. der Nassimprägnierung ist das nicht möglich. Zudem haben Elektronenstrahl-Mikroanalyse-Untersuchungen (ESMA) gezeigt, das die Konzentration des abgeschiedenen Palladiums innerhalb der feinporösen Schicht konstant ist, d.h. es treten keine Konzentrationsgradienten nach innen hin auf. Fig. 5 zeigt eine ESMA-Analyse einer beschichteten keramischen Membran mit einer ZrO₂-Deckschicht und einem Träger aus α-Al₂O₃. Dargestellt sind die Konzentration von Zr, Al und Pd über den Abstand von der Außenseite der Membran. Nach der in Beispiel 2 beschriebenen Methode wurden auf einem 10 cm langen rohrförmigen Membranstück 33,4 mg Palladium abgeschieden. Die Analyse zeigt überraschenderweise, dass die Palladium-Konzentration in der ZrO₂-Deckschicht nicht von außen nach innen abnimmt, sondern sie verläuft relativ konstant. Die Pd-Konzentration steigt sogar leicht nach innen zu an. Mit dem Ende der ZrO₂-Deckschicht nimmt auch der Palladiumgehalt sprunghaft ab. Im Aluminiumträger wird kaum Palladium abgeschieden.

Herkömmliche CVD-Beschichtungstechniken erzeugen dünne Filme auf einer Substratoberfläche, sie sind also Oberflächenbeschichtungsmethoden. Mit dem erfindungsgemäßen CVD-Beschichtungsverfahren können katalytische Komponenten auch in die Tiefe abgeschieden werden. Durch Variation der Menge an Lösungsvermittler kann bei der Beschichtung die Eindringtiefe in eine poröse keramische Struktur gesteuert werden. Wird mehr Vaseline verwendet und lässt man die Vaseline in den Träger eindringen, kann der grobporöse keramische Träger ebenfalls beschichtet werden. Die verwendete Menge Vaseline, die Zeit, in der sich die Vaseline verteilen kann, und auch die Temperatur bestimmen die Eindringtiefe der Vaseline und damit auch die Abscheidung des Palladiums. Fig. 6 zeigt ein Beispiel, bei dem Palladium unterschiedlich tief in eine keramische Membran abgeschieden wurde. In Fig. 6, links, ist ein Stück keramische Membran zu sehen, bei der Palladium nur in der Deckschicht abgeschieden wurde. Bei Fig. 6, Mitte, und rechts, wurde ein grobporöser keramischer Träger teilweise bzw. vollständig beschichtet. Der Übergang vom beschichteten zum unbeschichteten Träger in Fig. 6, Mitte, ist sehr deutlich ausgeprägt. Um den Precursor tiefer in die keramische Membran eindringen zu lassen, wird eine dickere Schicht Vaseline auf die Außenseite der Membran aufgebracht. Beim anschließenden Erwärmen der Membran auf ca. 80 °C verflüssigt sich die Vaseline und wird komplett vom Porensystem der keramischen Membran aufgesaugt. Das Porensystem wird entsprechend der vorhandenen Menge an Lösungsvermittler von außen nach innen gefüllt. Das Eindringen des Lösungsvermittlers in eine poröse Struktur und somit die Palladiumabscheidung kann so hauptsächlich durch die Menge des Lösungsvermittlers, aber auch die Eindringzeit, sowie die dabei vorliegende Temperatur beeinflusst werden.

Durch Verwendung der Vaseline können bestimmte gewünschte Stellen auf einem keramischen oder kohlenstoffhaltigen Material beschichtet werden. Andere Stellen können ausgelassen werden. Das abzuscheidende Metall, z.B. Palladium, wird auf inerten Materialien schließlich immer dort abgeschieden, wo zuvor die Vaseline aufgebracht wurde. Fig. 7 zeigt ein Beispiel, bei dem bestimmte Stellen auf einem porösen keramischen Trägermaterial aus α-Al₂O₃ mit Palladium beschichtet sind, während gleichzeitig andere Stellen ausgespart geblieben sind. Zuvor wurde nur an den gewünschten Stellen der Lösungsvermittler aufgebracht. Nach der CVD-Beschichtung im Glasrohr zeigte sich, dass Palladium sich hauptsächlich an den Stellen abgeschieden hatte, wo zuvor der Lösungsvermittler aufgebracht wurde.

### Beispiel 6: Modifizierung einer keramischen Membran mit einer Kohlenstoffschicht und anschließende CVD-Beschichtung mit Palladium

Eine keramische Membran aus α-Al₂O₃ oder ZrO₂ weist eine sehr niedrige spezifische innere Oberfläche auf. Um in einer solchen keramischen Membran eine hohe Oberfläche zu erzeugen, kann sie durch Einbringen einer Kohlenstoffschicht mit hoher innerer Oberfläche in das Porensystem modifiziert werden. Auf dieser Kohlenstoffschicht kann anschließend entsprechend Beispiel 2 Palladium oder ein anderes katalytisch aktives Metall abgeschieden werden. Durch Änderung des Trägermaterials ist es zudem möglich, die katalytischen Eigenschaften der Membran zu ändern. So weist eine Kohlenstoffschicht eher hydrophobe Eigenschaften auf im Gegensatz zu einer reinen Keramikmembran.

Zur Beschichtung einer keramischen Membran oder eines anderen keramischen Trägers mit einer Kohlenstoffschicht mit hoher spezifischer innerer Oberfläche muss zunächst ein Polyfurfurylalkoholharz hergestellt werden. Dazu werden 100 ml des Monomers Furfurylalkohol (Fluka 48100) in ein 250 ml Becherglas gegeben. Mit einem Magnetrührer wird der Alkohol gerührt und anschließend werden 2 ml einer 65 %-igen Salpetersäure sehr langsam zugegeben. Das Becherglas wird mit einem Urglas abgedeckt, allerdings soll das Becherglas nicht verschlossen werden und der Alkohol soll in Kontakt mit der Umgebungsluft bleiben. Der Alkohol erwärmt sich auf ca. 40 °C und die leicht grüne Flüssigkeit verdunkelt sich durch die einsetzende Polymerisation. Der Alkohol wird einen Tag lang weiter gerührt. Während dieser Zeit findet die säurekatalysierte Polymerisation statt, die Flüssigkeit wird dunkler und viskoser. Am nächsten Tag wird das Harz langsam unter Rühren auf 80 °C erhitzt, die Temperatur wird eine Stunde beibehalten. Anschließend lässt man das Harz wieder abkühlen, wobei das Harz ständig gerührt wird und das Becherglas mit einem Urglas bedeckt bleibt. Das Rühren soll unter anderem verhindern, dass es durch die während der Polymerisation freiwerdende Wärme zu einem Siedeverzug kommt. Das Urglas ermöglicht einen Rückfluss der aufsteigenden Dämpfe und verhindert eine Verunreinigung des Harzes. Am dritten und vierten Tag wird das Polyfurfurylharz wiederum auf 80 °C erwärmt, die Temperatur eine Stunde beibehalten und danach wieder abgekühlt. Anschließend lässt man das Harz noch zwei Tage weiterrühren. Schließlich erhält man ein dunkelbraunes, viskoses Polyfurfurylalkoholharz, das zur Aufbewahrung in einer Kunststoffflasche abgefüllt werden kann. Das hergestellte Harz kann so mehrere Monate aufbewahrt werden.
Durch Variation der Polymerisationsbedingungen können Polyfurfurylharze unterschiedlicher Viskosität für unterschiedliche Anwendungen hergestellt werden. Dazu ist die Polymerisation bei 80 °C unterschiedlich lange oder unterschiedlich oft, oder die Polymerisation ist bei niedrigerer bzw. höherer Temperatur auszuführen. Allerdings sollte eine Temperatur von 90 °C nicht überschritten werden, da es durch die freiwerdende Reaktionswärme leicht zu einem Siedeverzug kommen kann. Durch Vei-mischen des Harzes mit Aceton kann es zudem für gewisse Anwendungen verdünnt werden.
Das so hergestellte Polyfurfurylalkoholharz kann nun auf verschiedene Arten auf eine keramische Membran aufgebracht werden, z.B. als dünner Film zur Herstellung einer Gastrennmembran, oder es kann in die Poren der feinporösen Schicht abgeschieden werden oder es kann nur auf die Porenwände der feinporösen Deckschicht aufgebracht werden.
Um nur die Porenwände der feinporösen Deckschicht einer Membran mit Kohlenstoff zu beschichten, werden zunächst die Poren der Membranschicht mit Polyfurfurylalkoholharz gefüllt. Das Harz kann dazu mit einem Pinsel oder in einer beliebigen Weise auf die Membranschicht aufgebracht werden. Nach einer Einwirkzeit von etwa 20 Minuten wird die rohrförmige Membran in einen Membranhalter eingebaut. Die Enden der Membran sind dabei mit Silikondichtungen abgedichtet. Durch Ausblasen des Harzes mit Druckluft bei einem Druck von 18 bar bis 20 bar wird das Harz aus den Poren wieder entfernt. Nur an den Porenwänden verbleibt ein dünner Film. Der Luftstrom durch die Membran wird für weitere 30 Minuten aufrecht erhalten bis das Harz an den Porenwänden trocken bzw. fest wird. Die Membran wird anschließend in einen normalen Laborofen überführt, dessen Temperatur von Raumtemperatur auf 250 °C innerhalb 60 Minuten erhöht wird. Bei 250 °C verbleibt die Membran für 2 Stunden im Luftstrom im Ofen. Die Farbe des Harzes verändert sich dabei von dunkelbraun zu grau-schwarz. Nach dem Abkühlen des Ofens wird die Membran in einen rohrförmigen Ofen mit Gasanschlüssen überführt. Die rohrförmige Membran befindet sich im Ofen in einem rohrförmigen Quarzrohr und wird von einem keramischen Halter so getragen, dass sie nicht die Wände des Quarzrohres berührt. Die Temperatur des Ofens wird mit einer Heizrate von 1 K/min auf 900 °C erhöht, wobei ein Heliumstrom (20 ml/min, Umgebungsdruck) mit einem Volumenanteil von 1 % bis 5 % Wasserstoff durch das Quarzrohr geleitet wird. Die Membran verbleibt bei 900°C unter Gasfluss für weitere 20 Stunden im Ofen, danach wird mit 1 K/min wieder auf Raumtemperatur abgekühlt. Die entstehende Kohlenstoffschicht in der Membran hat eine sehr hohe spezifische Oberfläche von etwa 1400 m²/g, weist ein kumulatives Mikroporenvolumen von ca. 0.5 cm³/g (bestimmt nach Horvath-Kawazoe, Dubinin-Radushkevich) sowie ein kumulatives Mesoporenvolumen von 1,35 cm³/g (bestimmt nach Barret, Joyner und Halenda) auf und leitet den elektrischen Strom. Durch Änderung der Pyrolysebedingungen (Temperatur, Aufheizrate, Spülgas etc.) können die Eigenschaften der Kohlenstoffschicht jedoch gezielt beeinflusst werden.

Anschließend kann die so modifizierte keramische Membran mit Kohlenstoff in den Porenwänden entsprechend Beispiel 2 mit Palladium oder einem anderen katalytisch aktiven Metall oder mit einer anderen katalytisch aktiven Verbindung beschichtet werden.

### Beispiel 7: Beschichtung unporöser, rauer keramischer Oberflächen

Neben porösen Materialien können auch unporöse Oberflächen, die über eine gewisse Oberflächenrauigkeit verfügen, mit katalytischen Metallen oder katalytischen Verbindungen beschichtet werden. Der organische Lösungsvermittler, z.B. Vaseline, wird dazu auf die zu beschichtende, raue Oberfläche gegeben. Beim anschließenden CVD-Beschichtungsvorgang wird der Lösungsvermittler durch Erwärmen flüssig und verteilt sich dadurch gleichmäßig in der rauen Oberfläche. Der metallorganische Precursor kann sich im organischen Lösungsvermittler lösen und zersetzt sich anschließend mit zunehmender Temperatur durch thermische Zersetzung in das Metall und den organischen Rest, während der Lösungsvermittler gleichzeitig verdampft. Die Rauigkeit der Oberfläche im Nanometer- oder Mikrometer-Bereich ist notwendig um den Lösungsvermittler aufnehmen zu können. Mit dieser Anwendung können z.B. die Kanäle eines monolithischen Katalysatorträgers oder eines Mikrostrukturreaktors beschichtet werden.

### Beispiel 8: Herstellung von Schalenkatalysatoren

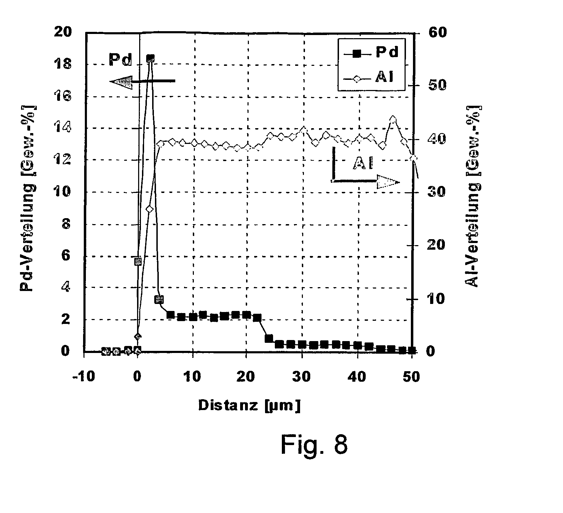

In Fig. 8 ist die Palladiumverteilung auf einer Membran zu sehen, auf deren Außenseite eine dünne Schicht (1 µm - 2 µm) γ-Al₂O₃ aufgebracht wurde. Die Messung der Verteilung erfolgte mit Elektronenstrahl-Mikroanalyse. Die Beschichtung dieser Membran wurde im Glasrohr entsprechend Beispiel 2, allerdings ohne ein vorheriges Aufbringen von Lösungsvermittler durchgeführt. Das γ-Al₂O₃ verfügt über eine hohe Oberfläche und aktive Zentren (OH-Gruppen an der Oberfläche), mit denen der Precursor reagieren kann. Dadurch scheidet sich Palladium bevorzugt in der sehr dünnen γ-Al₂O₃-Schicht ab. Kugelförmige Katalysatorkörner, auf deren Außenseite eine dünne γ-Al₂O₃-Schicht aufgebracht wurde, könnten somit beispielsweise auch gezielt in dieser Schicht mit Palladium beschichtet werden. Dadurch könnten Schalenkatalysatoren mit einer dünnen katalytischen Schicht auf der Außenseite der Katalysatorkörner hergestellt werden.

Wie in Beispiel 4 gezeigt wurde, kann über die Menge an verwendeten Lösungsvermittler die Eindringtiefe in eine poröse Schicht gesteuert werden. Dieser Effekt kann auch genutzt werden, um Schalenkatalysatoren herzustellen, auch wenn keine Schicht mit hoher Oberfläche oder aktiven Zentren auf den zu beschichtenden Katalysatorpellets vorliegt. Durch Aufbringen eines organischen Lösungsvermittlers, z.B. in einem Sprühverfahren, auf kugelförmigen, porösen Katalysatorträgern und einer sich anschließenden CVD-Beschichtung können katalytisch Metalle auf den Katalysatorkörnern abgeschieden werden. Die Dicke der sich ausbildenden katalytischen Schale kann über die aufgebrachte Menge an Lösungsvermittler, sowie über Einwirkzeit und Temperatur gesteuert werden.

## Patentansprüche

1. Verfahren zur Beschichtung eines Substrates mit einem Metall oder einer Metallverbindung, bei welchem das Substrat mittels einer gasförmigen, metallorganischen Ausgangsverbindung beschichtet wird, **dadurch gekennzeichnet, dass** vor der Beschichtung mittels der metallorganischen Ausgangsverbindung auf das Substrat ein organischer Lösungsvermittler für die metallorganische Ausgangsverbindung aufgebracht wird.

2. Verfahren nach Anspruch 1, **dadurch gekennzeichnet, dass** in einem geschlossenen Gefäß die metallorganische Ausgangsverbindung als fester Stoff und das mit dem Lösungsvermittler vorbehandelte Substrat eingebracht werden, dass anschließend das Gefäß evakuiert und erwärmt und **dadurch** die metallorganische Ausgangsverbindung sublimiert wird.

3. Verfahren nach zumindest einem der vorangehenden Ansprüche, **dadurch gekennzeichnet, dass** als organischer Lösungsvermittler Paraffine mit Erweichungsbereichen zwischen 30°C - 150°C und Verdampfungsbereichen zwischen 80°C und 300°C verwendet wird.

4. Verfahren nach Anspruch 3, **dadurch gekennzeichnet, dass** als organischer Lösungsvermittler weiße Vaseline verwendet wird.

5. Verfahren nach zumindest einem der vorangehenden Ansprüche, **dadurch gekennzeichnet, dass** als metallorganische Ausgangsverbindung Palladium(II)-Hexafluoracetylacetonat verwendet wird und zur Beschichtung des Substrates das Gefäß mit der Ausgangsverbindung und dem Substrat für mehrere Stunden in einem Ofen bei einer Temperatur von etwa 250°C verbleibt.

6. Verfahren nach zumindest einem der vorangehenden Ansprüche, **dadurch gekennzeichnet, dass** der organische Lösungsvermittler selektiv auf das Substrat aufgebracht wird.

7. Verfahren nach zumindest einem der vorangehenden Ansprüche, **dadurch gekennzeichnet, dass** es sich bei dem Substrat um eine poröse, keramische Membran und bei der Beschichtung um katalytisch aktive Komponenten handelt.

8. Verfahren nach zumindest einem der vorangehenden Ansprüche, **dadurch gekennzeichnet, dass** das zu beschichtende Substrat eine poröse keramische Membran mit symmetrischem oder asymmetrischem Aufbau ist.

9. Verfahren nach zumindest einem der vorangehenden Ansprüche, **dadurch gekennzeichnet, dass** das zu beschichtende Substrat eine poröse Glasmembran mit symmetrischem oder asymmetrischem Aufbau ist.

10. Verfahren nach zumindest einem der vorangehenden Ansprüche, **dadurch gekennzeichnet, dass** das zu beschichtende Substrat eine poröse metallische Membran mit symmetrischem oder asymmetrischem Aufbau ist.

11. Verfahren nach zumindest einem der vorangehenden Ansprüche, **dadurch gekennzeichnet, dass** das zu beschichtende Substrat eine poröse Kohlenstoffmembran mit symmetrischem oder asymmetrischem Aufbau oder eine poröse, kohlenstoffhaltige, anorganische Membran ist.

12. Verfahren nach zumindest einem der vorangehenden Ansprüche, **dadurch gekennzeichnet, dass** in den Poren oder auf der Oberfläche eines keramischen Trägermaterials vor der CVD-Abscheidung der katalytisch aktiven Komponenten eine mikroporöse, leitfähige Kohlenstoffschicht mit hoher innerer Oberfläche durch Pyrolyse eines Polyfurfurylalkoholharzes erzeugt wird.

13. Verfahren nach zumindest einem der vorangehenden Ansprüche, **dadurch gekennzeichnet, dass** das zu beschichtende Substrat ein anorganischer poröser Katalysatorträger in Pelletform, z.B. aus Aluminiumoxid, Zirkondioxid, Siliziumdioxid, Titandioxid, Magnesiumoxid oder aus einem anderen häufig als Katalysatorträger eingesetzten Material, ist.

14. Verfahren nach zumindest einem der vorangehenden Ansprüche, **dadurch gekennzeichnet, dass** der Abscheideort auf einem unporösen oder porösen Trägermaterial durch ungleichmäßig verteilte Anwendung des organischen Lösungsvermittlers vor der Abscheidung gezielt gesteuert wird.

15. Verfahren nach zumindest einem der vorangehenden Ansprüche, **dadurch gekennzeichnet, dass** die Abscheidetiefe in einem porösen Trägermaterial durch Anwendung einer bestimmten Menge des organischen Lösungsvermittlers vor der Abscheidung gezielt gesteuert wird.

16. Verfahren nach zumindest einem der vorangehenden Ansprüche, **dadurch gekennzeichnet, dass** durch die Steuerung der Abscheidetiefe der katalytischen Komponenten in einem porösen Trägermaterial in Pelletform Schalenkatalysatoren hergestellt werden.

17. Verfahren nach zumindest einem der vorangehenden Ansprüche, **dadurch gekennzeichnet, dass** als katalytisch aktive Komponenten Edelmetalle, wie z.B. Palladium, Platin, Rhodium, Silber oder Gold eingesetzt werden.

18. Verfahren nach zumindest einem der vorangehenden Ansprüche, **dadurch gekennzeichnet, dass** als katalytisch aktive Komponenten Nebengruppenmetalle, wie z.B. Nickel, Kupfer, Zink oder Zinn eingesetzt werden.

19. Verfahren nach zumindest einem der vorangehenden Ansprüche, **dadurch gekennzeichnet, dass** als katalytisch aktive Komponenten Metallverbindungen eingesetzt werden, die beim Zerfall der metallorganischen Ausgangsverbindungen oder durch eine anschließende Nachbehandlung der abgeschiedenen Metalle entstehen.

## Claims

1. A method for coating a substrate with a metal or a metallic compound wherein the substrate is coated by means of a gaseous organometallic parent compound, **characterised in that** an organic solubiliser for the organometallic parent compound is applied to the substrate before the coating by means of the organometallic parent compound.

2. The method according to claim 1, **characterised in that** the organometallic parent compound in the form of a solid and the substrate pre-treated with the solubiliser are inserted in a closed receptacle, said receptacle is then evacuated and heated and said organometallic parent compound is thereby sublimated.

3. The method according to at least one of the preceding claims, **characterised in that** paraffins having softening ranges between 30°C and 150°C and vaporisation ranges between 80°C and 300°C are used as organic solubilisers.

4. The method according to claim 3, **characterised in that** white petroleum jelly is used as organic solubiliser.

5. The method according to at least one of the preceding claims, **characterised in that** palladium(II) hexafluoroacetyl acetonate is used as organometallic parent compound and that for coating the substrate the receptacle containing the parent compound and the substrate is left for several hours in a furnace at a temperature of about 250°C.

6. The method according to at least one of the preceding claims, **characterised in that** the organic solubiliser is applied selectively to the substrate.

7. The method according to at least one of the preceding claims, **characterised in that** the substrate comprises a porous ceramic membrane and the coating comprises catalytically active components.

8. The method according to at least one of the preceding claims, **characterised in that** the substrate to be coated is a porous ceramic membrane having a symmetrical or asymmetrical structure.

9. The method according to at least one of the preceding claims, **characterised in that** the substrate to be coated is a porous glass membrane having a symmetrical or asymmetrical structure.

10. The method according to at least one of the preceding claims, **characterised in that** the substrate to be coated is a porous metallic membrane having a symmetrical or asymmetrical structure.

11. The method according to at least one of the preceding claims, **characterised in that** the substrate to be coated is a porous carbon membrane having a symmetrical or asymmetrical structure or a porous carbon-containing inorganic membrane.

12. The method according to at least one of the preceding claims, **characterised in that** a micro-porous conductive carbon layer having a high inner surface area is produced by pyrolysis of a polyfurfuryl alcohol resin in the pores or on the surface of a ceramic support material before the CVD deposition of the catalytically active components.

13. The method according to at least one of the preceding claims, **characterised in that** the substrate to be coated is an inorganic porous catalyst support in pellet form, e.g. comprising aluminium oxide, zirconium dioxide, silicon dioxide, titanium dioxide, magnesium dioxide or another material frequently used as catalyst support.

14. The method according to at least one of the preceding claims, **characterised in that** the deposition site on a non-porous or porous support material is specifically controlled by non-uniformly distributed application of the organic solubiliser prior to deposition.

15. The method according to at least one of the preceding claims, **characterised in that** the deposition depth in a porous support material is specifically controlled by application of a specific quantity of the organic solubiliser prior to deposition.

16. The method according to at least one of the preceding claims, **characterised in that** by controlling the deposition depth of the catalytic components in a porous support material, shell catalysts are produced in pellet form.

17. The method according to at least one of the preceding claims, **characterised in that** precious metals such as, for example, palladium, platinum, rhodium, silver or gold are used as catalytically active components.

18. The method according to at least one of the preceding claims, **characterised in that** transition metals such as, for example, nickel, copper, zinc or tin are used as catalytically active components.

19. The method according to at least one of the preceding claims, **characterised in that** metal compounds produced during the decomposition of the organometallic parent compounds or by a subsequent after-treatment of the deposited metals are used as catalytically active components.

## Revendications

1. Procédé de revêtement d'un substrat avec un métal ou un composé métallique, du type selon lequel le substrat est revêtu au moyen d'un composé initial organométallique gazeux, **caractérisé en ce qu'**avant le revêtement au moyen du composé initial organométallique est appliqué sur le substrat un promoteur organique de solubilisation pour le composé initial organométallique.

2. Procédé selon la revendication 1, **caractérisé en ce que** dans une enceinte fermée sont introduits le composé initial organométallique à l'état solide et le substrat prétraité avec le promoteur de solubilisation, **en ce qu'**ensuite l'enceinte est mise sous vide et chauffée, et que de ce fait le composé initial organométallique soit sublimé.

3. Procédé selon au moins l'une des revendications précédentes, **caractérisé en ce qu'**en tant que promoteur organique de solubilisation sont utilisées des paraffines ayant des domaines de températures de ramollissement compris entre 30°C et 150°C et des domaines de températures de vaporisation compris entre 80°C et 300°C.

4. Procédé selon la revendication 3, **caractérisé en ce qu'**en tant que promoteur organique de solubilisation est utilisée de la vaseline blanche.

5. Procédé selon au moins l'une des revendications précédentes, **caractérisé en ce qu'**en tant que composé initial organométallique est utilisé l'hexafluoroacétylacétonate de Palladium (II) et **en ce qu'**en vue du revêtement du substrat l'enceinte avec le composé initial et le substrat séjourne pendant plusieurs heures dans un four à une température de l'ordre de 250°C.

6. Procédé selon au moins l'une des revendications précédentes, **caractérisé en ce que** le promoteur organique de solubilisation est appliqué de manière sélective sur le substrat.

7. Procédé selon au moins l'une des revendications précédentes, **caractérisé en ce qu'**il s'agit pour le substrat d'une membrane céramique poreuse et pour le revêtement de composants catalytiquement actifs.

8. Procédé selon au moins l'une des revendications précédentes, **caractérisé en ce que** le substrat à revêtir est une membrane céramique poreuse, présentant une structure symétrique ou asymétrique.

9. Procédé selon au moins l'une des revendication précédentes, **caractérisé en ce que** le substrat à revêtir est une membrane poreuse en verre, présentant une structure symétrique ou asymétrique.

10. Procédé selon au moins l'une des revendications précédentes, **caractérisé en ce que** le substrat à revêtir est une membrane métallique poreuse, présentant une structure symétrique ou asymétrique.

11. Procédé selon au moins l'une des revendications précédentes, **caractérisé en ce que** le substrat à revêtir est une membrane poreuse en carbone, présentant une structure symétrique ou asymétrique, ou une membrane minérale, poreuse et contenant du carbone.

12. Procédé selon au moins l'une des revendications précédentes, **caractérisé en ce que** dans les pores ou à la surface d'un matériau-support céramique et avant processus d'isolement ou séparation C.V.D des composants catalytiquement actifs est générée, par pyrolyse d'une résine polyfurfurolique, une couche carbonée, conductrice, microporeuse et ayant une surface spécifique élevée.

13. Procédé selon au moins l'une des revendications précédentes, **caractérisé en ce que** le substrat à revêtir est un support de catalyseur poreux, minéral, sous forme de pastilles, par exemple à base d'alumine, de zircone, de silice, de dioxyde de titane, de magnésie ou d'un autre matériau employé fréquemment comme support de catalyseur.

14. Procédé selon au moins l'une des revendications précédentes, **caractérisé en ce que** la localisation de la zone d'isolement sur un matériau-support, non poreux ou poreux, est contrôlée de manière ciblée et avant le processus d'isolement, par mise en application irrégulièrement répartie du promoteur de solubilisation.

15. Procédé selon au moins l'une des revendications précédentes, **caractérisé en ce que** la profondeur de la zone d'isolement dans un matériau-support poreux est contrôlée de manière ciblée et avant le processus d'isolement, par mise en application d'une quantité déterminée du promoteur organique de solubilisation.

16. Procédé selon au moins l'une des revendications précédentes, **caractérisé en ce que** par le contrôle de la profondeur de la zone d'isolement des composants catalytiques dans un matériau-support poreux et sous forme de pastilles sont préparés des catalyseurs en écailles.

17. Procédé selon au moins l'une des revendications précédentes, **caractérisé en ce qu'**en tant que composants catalytiquement actifs sont employés des métaux nobles, tels que par exemple le palladium, le platine, le rhodium, l'argent ou l'or.

18. Procédé selon au moins l'une des revendications précédentes, **caractérisé en ce qu'**en tant que composants catalytiquement actifs sont employés des métaux de transition, tels que par exemple le nickel, le cuivre, le zinc ou l'étain.

19. Procédé selon au moins l'une des revendications précédentes, **caractérisé en ce qu'**en tant que composants catalytiquement actifs sont employés des composés métalliques, qui se forment lors de la dissociation des composés initiaux organométalliques ou par un traitement subséquent des métaux isolés ou séparés.
